# EUROPEAN PATENT APPLICATION

(11) **EP 2 299 501 A1**
(43) Date of publication of application: **23.03.2011**
(21) Application number: 09011796.1
(22) Date of filing: 16.09.2009
(51) Int. Cl.: H01L 31/18, H01L 31/042, H01L 31/05

(54) **Method and apparatus for providing a solar cell with a solder ribbon**

(71) Applicant: 3S Industries AG, 3250 Lyss (CH)
(72) Inventor: Risch, Wolfgang, 79224 Umkirch (DE); Zönnchen, Jörg, 79110 Freiburg (DE); Kamasinski, Karol, 79110 Freiburg (DE)
(74) Representative: Fischer, Britta Ruth

(57) **Abstract**

The invention relates to a method for providing a solar cell (2) with a solder ribbon (3), the solar cell (2) having at least one bus bar (7), wherein flux (4; 4.1; 4.2; 4.3; 4.4) is applied by means of at least one automatically controlled spray head (5; 6) and the solder ribbon (3) is connected to a bus bar (7) by means of at least one automatically controlled soldering unit, and wherein the flux (4; 4.1; 4.2; 4.3; 4.4) is only applied to those locations of the solder ribbon (3) that are to be connected to the bus bar (7) and/or that the flux (4; 4.1; 4.2; 4.3; 4.4) is only applied to those locations of the bus bars (7) that is to be connected to the solder ribbon (3). The invention further relates to an apparatus for providing a solar cell (2), that has at least one bus bar (7), with a solder ribbon (3) according to such a method.

## Description

The invention relates to a method and an apparatus for providing a solar cell, also called photovoltaic cell, with a solder ribbon.

In order to manufacture solar modules that can for example be placed on a roof of a building for solar energy generation, several solar cells with bus bars are typically connected in series with each other to form so called strings. For this the bus bars of the solar cells are connected with the bus bars of neighbouring solar cells by means of solder ribbons. A solder ribbon is thereby connected to the positive terminal of a solar cell and to the negative terminal of the neighbouring solar cell, i.e. the solder ribbon is alternatingly connected with the lower side of one solar cell and with the upper side of the neighbouring solar cell. The solder ribbons are typically made of tinned copper and are connected with the bus bars by means of one or more soldering units. A solar cell can have several bus bars, in particular between one to three bus bars, which requires an equal amount of solder ribbons for forming a string. The strings are formed in an apparatus called stringer.

After the strings have been formed they are typically transferred to a quality testing station for inspection of the alignment of the solar cells and the solder ribbons as well as for the detection of possible breakage. Then the strings are placed next to each other and cross-linked to obtain a solar cell matrix. After the cross-linking the solar cell matrix is laid sunny side down upon a glass plate with an adhesive layer and covered with a glass or plastics cover with an adhesive layer. Then it is laminated in a laminator for protection purposes.

For facilitating the soldering when the solar cells are connected with the solder ribbons to form the strings, flux is typically employed as chemical cleaning agent to remove oxidation from the metals to be joined and to prevent the formation of metal oxides. Furthermore, the provision of flux allows the solder to flow easily rather than forming beads. The flux is usually provided by the solder ribbon or the solar cell running through a flux bath or by applying the flux to the solder ribbon with a brush or a spray head with the entire solder ribbon being brushed. The known methods have the disadvantage that the flux does not only come to lie on the bus bars but often also on the semiconductor material of the solar cells which might cause damage to it and might impair the laminating process of the solar modules formed from the solar cells. In such a case, the flux might evaporate over time, even when inside a solar panel.

It is an object of the invention to provide a method and an apparatus for providing a solar cell with a solder ribbon by which the above disadvantages can be avoided. It is a further object of the invention to provide a method and an apparatus for providing a solar cell with a solder ribbon by which the fluxing and soldering process can be expedited. It is a still further object of the invention to provide a method and an apparatus for providing a solar cell with a solder ribbon by which the amount of required flux can be reduced.

In order to implement these and still further objects of the invention, which will become more readily apparent as the description proceeds, a method for providing a solar cell that has at least one bus bar with a solder ribbon is provided, wherein flux is applied by means of at least one automatically controlled spray head and the solder ribbon is connected to the bus bar by means of at least one automatically controlled soldering unit. According to the invention the flux is only applied to those locations of the solder ribbon that shall be connected to the bus bar by means of the one or more soldering units. Alternatively or additionally, the flux is only applied to those locations of the bus bar that shall be connected to the solder ribbon by means of the one or more soldering units. I.e. the locations of the applied flux correspond to/correlate with the locations at which the solder ribbon is soldered after application of the flux.

The apparatus according to the invention comprises at least one automatically controlled spray head for applying flux and at least one automatically controlled soldering unit for connecting a solder ribbon to a bus bar. The spray head is controlled such that the flux is applied only to those locations of the solder ribbon that shall be connected to the bus bar by means of the one or more soldering units when the apparatus is operated. Alternatively or additionally, the spray head is controlled such that the flux is applied only to those locations of the bus bar that shall be connected to the solder ribbon by means of the one or more soldering units when the apparatus is operated. For controlling the at least one spray head a control unit is provided that may form part of the spray head.

The method and the apparatus of the invention have the advantages that less flux is required and that the fluxing and soldering process can be performed faster than with the above-mentioned known methods and corresponding apparatuses. The method and the apparatus of the invention can of course also be applied if the solar cells have several bus bars, wherein each bus bar shall be connected with a solder ribbon.

Preferably a preheating unit is provided for preheating the solder ribbon and/or the bus bar to reduce the amount of alcohol in the flux and/or to activate the flux. For the preheating, the preheating unit can employ any kind of heating mechanism/technology such as a laser, a heat die, a soldering iron and/or the provision of heated air. The preheating unit and hence the temperature it provides are preferably controllable. If the solder ribbon and the bus bar shall be connected by wet soldering, the preheating unit is preferably controlled such that the temperature it generates is less than 80 degrees Celsius so that relatively little solvent, e.g. alcohol, is evaporated from the flux. If the solder ribbon and the bus bar shall be connected by dry soldering, the preheating unit is preferably controlled such that the temperature it generates is equal to or higher than 80 degrees Celsius so that a relatively large amount of alcohol is evaporated from the flux and the amount of solvent is thereby reduced. By setting the temperature that the preheating unit generates equal to or higher than 100 degrees Celsius the flux can be activated, whereas if the temperature the preheating unit generates remains lower than 100 degrees Celsius, activation of the flux does not occur. The preheating unit can be given by or comprise a soldering tip, a laser, a unit for generating ultrasound and/or a unit for generating hot air among others. The actual connecting of the solder ribbon to the bus bar by soldering takes place by a temperature of approximately 100 to 120 degrees Celsius. During the soldering preferably just the areas of the solder ribbon and/or the bus bar are heated onto which flux has been previously applied. Alternatively, an elongated area of the solder ribbon and/or the bus bar can be heated, that includes the areas onto which flux has been applied, wherein the direction of elongation corresponds to the longitudinal extension of the solder ribbon and/or the bus bar. Also in the later case soldering mainly takes place at the locations onto which flux has been applied.

Preferentially a monitoring unit is provided that preferably comprises a camera, preferably a camera that can take range images, i.e. 3D-images. A 2D-camera or a line sensor may also be used. The monitoring unit monitors the position of the bus bars so that the position of the one or more spray heads may be controlled and corrected by the control unit in dependence on the monitored positions of the bus bars to ensure that the flux is applied to those locations on the bus bars that shall be connected to solder ribbon, i.e. to the "correct" locations. The monitoring by the monitoring unit may be done before the flux is actually applied for process control and/or after application of the flux for quality inspection.

The monitoring unit furthermore preferably detects and monitors the actual locations on the solder ribbon and/or the bus bar on which the flux is or has been, respectively, applied by the one or more spray heads. These monitored actual locations of the flux are then compared by the monitoring unit or a control unit with those predetermined locations of the solder ribbon and/or the bus bar that shall be connected to the bus bar and/or the solder ribbon by means of the one or more soldering units. If there is a difference between the monitored actual locations to which flux has been applied and the predetermined locations that shall be connected by soldering, then the position of the one or more spray heads is controlled by a control unit such that this difference converges to zero or is at least minimized.

If the one or more spray heads are wider than a bus bar and/or a solder ribbon, onto which flux shall be applied, and comprise a set of spray nozzles that are arranged in an array, then the control unit is preferably construed such that it can control the one or more spray heads such that flux is dispersed from a subset of spray nozzles that are arranged in an area that is not wider than the bus bar and/or the solder ribbon.

Further advantageous features and applications of the invention can be found in the dependent claims as well as in the following description of the drawings illustrating the invention. In the drawings like reference signs designate the same or similar parts throughout the several figures of which:
Fig. 1 schematically shows a side view of a string,
Fig. 2 schematically shows a partial side view of a first embodiment of an apparatus according to the invention,
Fig. 3 schematically shows a partial side view of a second embodiment of an apparatus according to the invention,
Fig. 4 schematically shows a top view onto a solder ribbon or a bus bar with flux applied, and
Fig. 5 shows a flow chart of a method according to the invention.

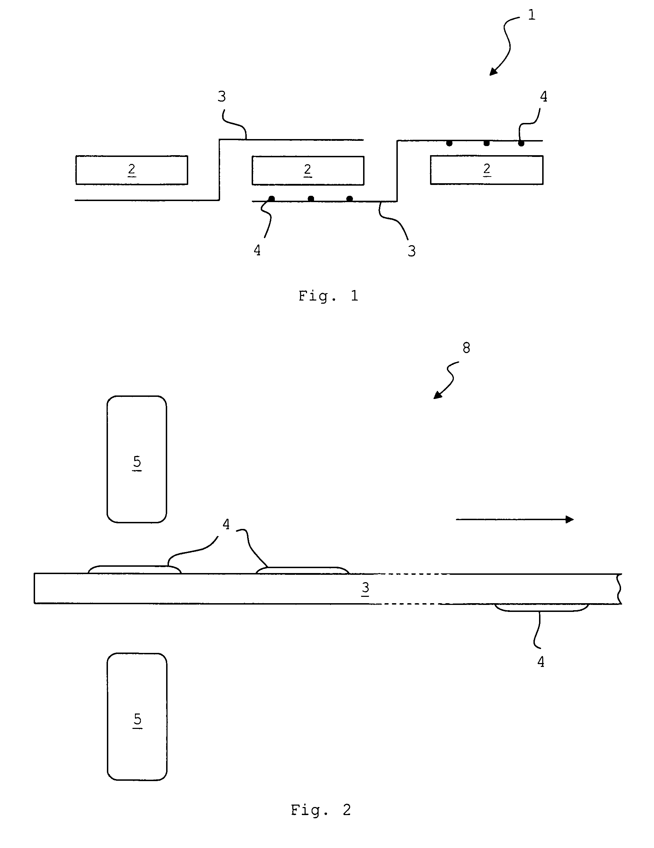

Figure 1 schematically shows a string 1 that exemplarily comprises three solar cells 2 that are connected to each other in series by solder ribbons 3 (for ease of presentation the solar cells 2 and the solder ribbons 3 are depicted in exploded view). The solder ribbons 3 connect a positive terminal of one solar cell 2 to a negative terminal of a neighbouring solar cell 2, i.e. the solder ribbons 3 are alternatingly connected to an upper surface and a lower surface of neighbouring solar cells 2. The upper surface is defined as that surface that faces the sun when the solar cells 2 are put into operation. The lower surface is the surface opposite to the upper surface. The length of a solder ribbon 3 is approximately twice the length of a solar cell 2. Where the solder ribbon 3 faces either the upper surface or the lower surface of a solar cell 2 it is provided with flux 4 at specific locations on the upper side and the lower side of the solder ribbon 3 and only at these specific locations. These specific locations correspond to those predetermined locations that shall later be connected to a bus bar (not shown in Figure 1) by means of one or more soldering units. Alternatively or additionally, the flux can be applied to specific locations on the one or more bus bars.

Figure 2 schematically shows part of a first embodiment 8 of an apparatus of the invention in side view with spray heads 5 and a solder ribbon 3 running in between them. Flux 4 is applied onto the upper and lower sides of the solder ribbon 3 only at those locations where the solder ribbon 3 is going to be connected with a bus bar of a solar cell by soldering. For the spraying of the flux there are a spray head 5 positioned above and another spray head 5 positioned below the solder ribbon 3, the spray nozzles of the spray heads 5 pointing towards the solder ribbon 3. Of course, there may be provided several spray heads 5 above and below the solder ribbon 3. The arrow indicates the direction of movement of the solder ribbon 3, with the position of the spray heads 5 fixed. The solder ribbon 3 is typically held, stretched and clockedly moved by grabbers (not shown).

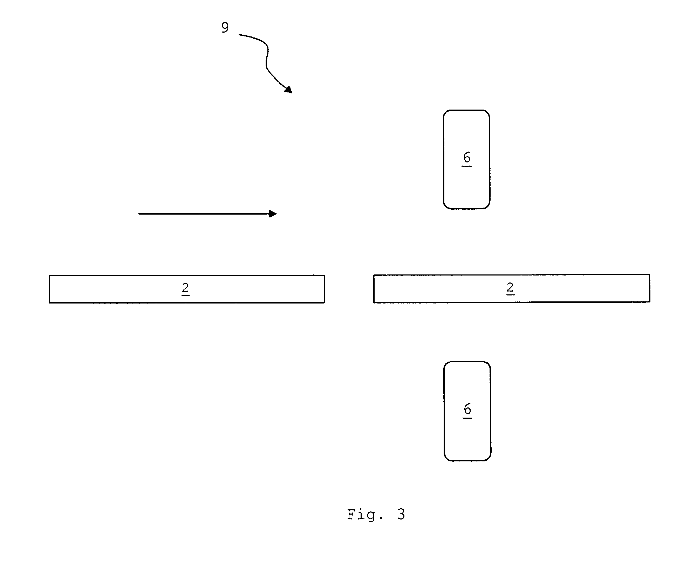

Figure 3 schematically shows part of a second embodiment 9 of an apparatus according to the invention with spray heads 6 and solar cells 2 running in between them. One spray head 6 is positioned above the solar cells 2 and one spray head 6 is positioned below the solar cells 2. Of course, there may be provided several spray heads 6 above and below the solar cells 2, while the position of the spray heads remains fixed. The spray heads 6 spray flux (not shown) onto the bus bars (not shown) of the solar cells 2. The arrow indicates the direction of movement of the bus bars 2. The solar cells 2 are typically held and clockedly moved by holders with suction cups (not shown) or by two parallel running conveyor belts (not shown) with each conveyor belt supporting a border area of a solar cell 2 which has no bus bars.

In the embodiments 8, 9 shown in Figures 2 and 3 the spray heads 5, 6 are controlled such by a control unit (not shown) that flux 4 is only applied to those locations on the solder ribbon 3 or the bus bar, respectively, of the solar cells 2 which are then connected to bus bar or the solder ribbon 3, respectively, by soldering. Of course, it is also possible to combine the embodiments 8, 9 shown in Figures 2 and 3 such that flux 4 is applied to the solder ribbon 3 and the bus bar but only at those locations where the bus bar and the solder ribbon 3 shall be connected.

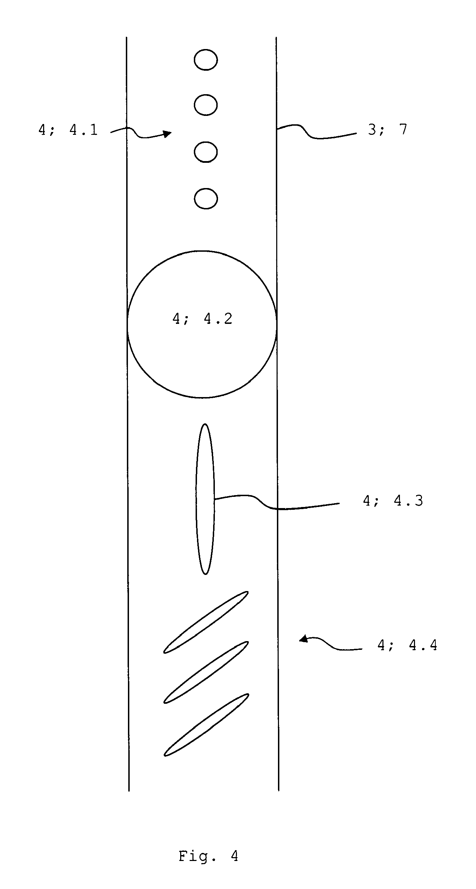

Figure 4 shows a top view of a solder ribbon 3 or a bus bar 7 of a solar cell, respectively, onto which flux has been sprayed by one or more spray heads 5, 6. The spray heads 5, 6 disperse the flux usually in the form of flux drops. By means of the control unit (not shown) the one or more spray heads 5, 6 are preferably controlled such that the size of the flux drops can be controlled as well as the pattern in which the flux drops are dispersed onto the solder ribbon 3/bus bar 7. Furthermore, the control unit may be construed such that it can control the speed of the flux drops dispersed by the one or more spray heads 5, 6, i.e. the speed with which the flux drops hit a solder ribbon 3 or a bus bar 7. The diameter of the flux drops that such can be obtained may e.g. vary between some micrometres and several millimetres. Different patterns may be obtained by controlling the position of the one or more spray head 5, 6 and by moving the one or more spray heads 5, 6 in a plane that lies in parallel to a surface of the solder ribbon 3 or the solar cell 2, respectively, by the control unit. For example, the position of a spray head 5, 6 can be controlled such that the flux is only dispersed in the middle or along a centre line of a solder ribbon 3/bus bar 7 so that contact of the flux with the actual semiconductor material of the solar cell can be advantageously avoided as the flux might damage the semiconductor material and thereby impede the functioning of the solar cell.

Figure 4 shows various examples of applied flux. At the top of the solder ribbon 3/bus bar 7 depicted in Figure 4 the flux 4 has been applied as relatively small flux drops 4.1 on a centre line of the solder ribbon 3/bus bar 7. Below the flux drops 4.1 a relatively large flux drop 4.2 has been dispersed whose diameter is approximately equal to the width of the solder ribbon 3/bus bar 7 but who does not go beyond the solder ribbon 3/bus bar 7 so that contact with the semiconductor material of the solar cell is avoided. Below the relatively large flux drop 4.2 a line 4.3 of flux has been dispersed on the centre line of the solder ribbon 3/bus bar 7. At the bottom of the solder ribbon 3/bus bar 7 the flux has been dispersed in a pattern of several inclined lines 4.4. The flux drop sizes and patterns shown in Figure 4 are only exemplarily. Several other possible flux drop sizes and patterns can be imagined.

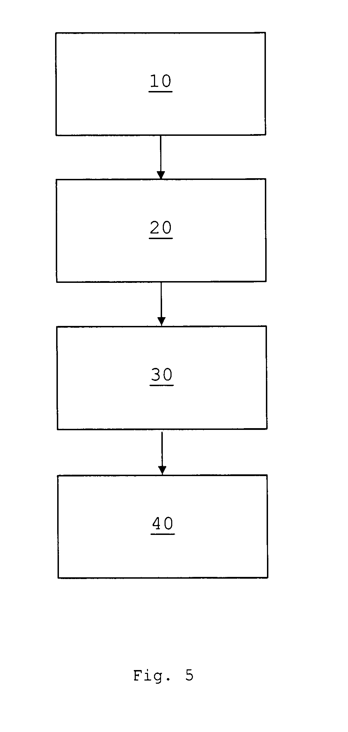

Figure 5 shows a flow chart of a method according to the invention. In a first step 10 either a solder ribbon or a bus bar, depending on where the flux shall be applied, is preheated by a preheating unit to a first predefined temperature for removing alcohol from the flux. If the first temperature is set below 80 degrees Celsius then enough alcohol remains in the flux that the solder ribbon and the bus bar can be connected by wet soldering. If the first temperature is set equal to or above 80 degrees Celsius, then enough alcohol is removed from the flux that the solder ribbon and the bus bar can be connected by dry soldering. The preheating preferably occurs only at those locations of the solder ribbon and/or the bus bar that shall be connected later on by soldering. The preheating unit may comprise several preheating subunits, each subunit being assigned to one of these locations.

In a second step 20 the temperature provided by the preheating unit may be set to a second predefined temperature that preferably is equal to or higher then 100 degrees Celsius if activating of the flux is desired before the actual soldering starts. Alternatively the second predefined temperature may be given by the first predefined temperature, if the first predefined temperature is smaller than 100 degrees Celsius, or it may be set to a temperature below 100 degrees Celsius if activation of the flux shall first occur with the soldering. In step 20 the preheating preferably also occurs only at those locations of the solder ribbon and/or the bus bar that shall be connected later on by soldering.

In a third step 30 the flux is applied by the one or more spray heads to the solder ribbon and/or the bus bar with specific flux drop sizes and/or in specific patterns as described exemplarily with regard to Figure 4, but only at those locations of the solder ribbon and/or the bus bar that shall be connected later on by soldering.

In a fourth step 40, the solder ribbon and the bus bar are then soldered together by means of one or more soldering units at the predetermined locations.

The steps 10 and 20 are optional, wherein either both steps 10 and 20, only step 10 or only step 20 or neither step 10 nor step 20 may be performed. Furthermore, it is preferably monitored by a monitoring unit if those locations onto which flux is applied actually correspond to those predetermined locations that shall be soldered. If such is not the case, the position of the one or more spray heads is corrected as described above.

## Claims

1. A method for providing a solar cell (2) with a solder ribbon (3), the solar cell (2) having at least one bus bar (7), wherein flux (4; 4.1; 4.2; 4.3; 4.4) is applied by means of at least one automatically controlled spray head (5; 6) and the solder ribbon (3) is connected to a bus bar (7) by means of at least one automatically controlled soldering unit, **characterized in that** the flux (4; 4.1; 4.2; 4.3; 4.4) is only applied to those locations of the solder ribbon (3) that are to be connected to the bus bar (7) and/or that the flux (4; 4.1; 4.2; 4.3; 4.4) is only applied to those locations of the bus bars (7) that is to be connected to the solder ribbon (3).

2. The method according to claim 1, wherein the spray head (5, 6) is controlled such by means of a control unit that the flux (4; 4.1; 4.2; 4.3; 4.4) can be applied with various drop sizes and/or in different patterns and/or with different speeds.

3. The method according to claim 1 or 2, wherein the solder ribbon (3) or/and the bus bar (7) are preheated before the application of the flux (4; 4.1; 4.2; 4.3; 4.4) and/or before being soldered to reduce the solvent of the flux (4; 4.1; 4.2; 4.3; 4.4).

4. The method according to claim 3, wherein the temperature for preheating is smaller than 80 degrees Celsius if the solder ribbon (3) shall be connected to the bus bar (7) by wet soldering.

5. The method according to claim 3, wherein the temperature for preheating is greater or equal to 80 degrees Celsius to reduce the amount of solvent.

6. The method according to one of the preceding claims, wherein the flux is exposed to a temperature that is greater or equal to 100 degrees Celsius to activate the flux (4; 4.1; 4.2; 4.3; 4.4).

7. The method according to one of the preceding claims, wherein the actual locations on the solder ribbon (3) or the bus bar (7) to which the flux (4; 4.1; 4.2; 4.3; 4.4) is actually applied are monitored, and in particular wherein these actual locations are compared to those locations that are to be connected by means of the at least one soldering unit and the position of the at least one spray head (5; 6) is controlled such that the difference of the monitored actual locations and the locations that are to be connected is minimized.

8. An apparatus for providing a solar cell (2), that has at least one bus bar (7), with a solder ribbon (3) according to a method of one of the preceding claims, the apparatus (8; 9) comprising at least one automatically controlled spray head (5; 6) for applying flux (4; 4.1; 4.2; 4.3; 4.4) and at least one automatically controlled soldering unit for connecting the solder ribbon (3) to a bus bar (7), **characterized in that** the spray head (5; 6) is controllable such that the flux is applied only to those locations of the solder ribbon (3) that are to be connected to the bus bar (7) and/or that the flux (4; 4.1; 4.2; 4.3; 4.4) is applied only to those locations of the bus bars (7) that are to be connected to the solder ribbon (3).

9. The apparatus according to claim 8, wherein a control unit is provided for controlling the position of the at least one spray head (5; 6) and/or the size of the flux drops of the at least one spray head (5; 6) disperses and/or the pattern in which the flux drops are dispersed by the at least one spray head (5; 6) and/or the speed of the flux drops of the at least one spray head (5; 6).

10. The apparatus according to claim 8 or 9, wherein a preheating unit is providing for preheating the solder ribbon (3) and/or the bus bar (7).

11. The apparatus according to claim 10, wherein the temperature of the preheating unit is controllable and in particular such controllable that a temperature below 80 degrees Celsius for wet soldering, above or equal to 80 degrees Celsius for dry soldering, and/or above or equal to 100 degrees Celsius for activation of the flux can be set.

12. The apparatus according to one of the claims 8 to 11, wherein a monitoring unit, in particular a camera, is provided for monitoring the actual locations on the solder ribbon (3) and/or the bus bar (7) to which the flux (4; 4.1; 4.2; 4.3; 4.4) is actually applied by the at least one spray head (5; 6).
